# EUROPEAN PATENT APPLICATION

(11) **EP 2 615 645 A1**
(43) Date of publication of application: **17.07.2013**
(21) Application number: 12150571.3
(22) Date of filing: 10.01.2012
(51) Int. Cl.: H01L 31/0392

(54) **Composite poly-silicon substrate and solar cell having the same**

(71) Applicant: Innovation & Infinity Global Corp., Hsinchu City (TW)
(72) Inventor: Chu, Chao-Chieh, 300 Hsinchu City (TW)
(74) Representative: Viering, Jentschura & Partner

(57) **Abstract**

A composite poly-silicon substrate for solar cell having a first substrate layer and a second substrate layer is disclosed. The purity of the first substrate layer ranges from 2N to 3N. The second substrate layer is formed on the first substrate layer, and the purity of the second substrate layer ranges from 6N to 9N.

## Description

### BACKGROUND OF THE INVENTION

### 1. Field of the Invention

The instant disclosure relates to a poly-silicon substrate and solar cell having the same; in particular, to a composite poly-silicon substrate and solar cell having the same.

### 2. Description of Related Art

The over-consumption of fossil fuels has lead to present day energy crisis, besides being a major contributor to the increase in the carbon dioxide concentration The increase in the concentration of carbon dioxide exacerbates the existing Greenhouse effect. Meanwhile, solar energy is considered to be the largest natural energy source on Earth. The energy from the sun that reaches the Earth's surface daily accounts up to 25% of the global oil reserves. In addition, solar energy results in zero pollution. Moreover, recent advancement in materials science, particularly in the semiconductor field , has gradually increased the solar power efficiency. Taking a polymer solar cell as an example. When sun light falls on the cell, a polymer-based photoactive layer is used in the solar cell for absorbing light. The absorption of light, or photons, forms exciton electron-hole pairs. The electron and hole pairs are dissociated through the provision of an interface across which the chemical potential of electrons decreases. After exciton dissociation, the electron and hole are collected at contacts in creating current flow.

Solar cells can be fabricated from crystalline silicon blocks. One of the categories of the "solar grade silicon" is the polycrystalline silicon, or poly-silicon. Poly-silicon solar cells can be configured as bulk or thin-film poly-silicon solar cells. The poly-silicon solar cells are cost-effective and provide greater usable surface area.

However, existing poly-silicon wafers used for high-efficiency photovoltaic applications must have a high level of purity. The purification process is lengthy, costly, and not environmental friendly. In addition, the efficiency and operation of a solar cell strongly depends on the nanomorphology of the active layer, where the active layer is usually only 5 to 10 micrometers thick. Therefore, the unused portion of the high-purity substrate is thus wasted. Thus, to reduce the manufacturing cost of solar cells while achieving high photovoltaic effect are eagerly being pursued.

### SUMMARY OF THE INVENTION

The instant disclosure provides a composite poly-silicon substrate for solar cell. The poly-silicon substrate is a composite double-layered substrate, which includes a high purity silicon layer formed on a lower purity silicon substrate to reduce manufacturing cost.

The poly-silicon substrate of the instant disclosure comprises: a first substrate layer having a purity ranging from 2N to 3N; and a second substrate layer having a purity ranging from 6N to 9N formed on the first substrate layer.

The instant disclosure also provides a solar cell having the aforementioned poly-silicon substrate.

For the gain, the instant disclosure employs semiconductor-based method to form a high purity epitaxial layer or sputtered layer on a low purity silicon substrate. This high purity overlayer is used as active layer of the solar cell. Thus, the conventional solar cell made with bulk silicon can be replaced to cut back the total usage of high purity silicon. Accordingly, the manufacturing cost of the solar cells can be reduced.

In order to further appreciate the characteristics and technical contents of the instant disclosure, references are hereunder made to the detailed descriptions and appended drawings in connection with the instant disclosure. However, the appended drawings are merely shown for exemplary purposes, rather than being used to restrict the scope of the instant disclosure.

### BRIEF DESCRIPTION OF THE DRAWINGS

Fig. 1 is a schematic view of a first substrate layer of the instant disclosure.

Fig. 2 is a schematic view of a composite poly-silicon substrate of the instant disclosure for a solar cell.

Fig. 3 is a schematic view of a solar cell of the instant disclosure.

### DETAILED DESCRIPTION OF THE EMBODIMENTS

The instant disclosure provides a composite poly-silicon substrate adaptable to a solar cell. The composite structure can reduce the usage of high purity poly-silicon to provide cost saving effect.

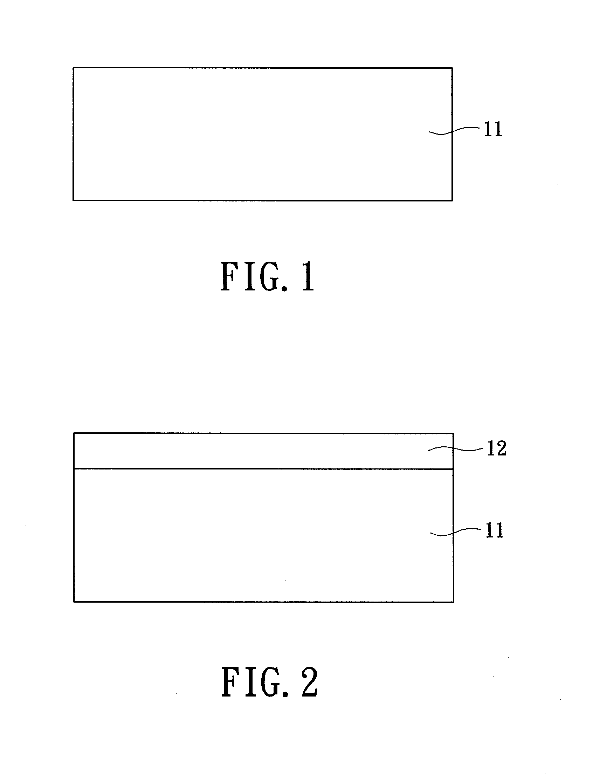

With reference to Figs. 1-2, the composite poly-silicon substrate includes a first substrate layer 11 and a second substrate layer 12 in a stacked configuration.

For the instant embodiment, the first substrate layer 11 is a low purity silicon. This first substrate layer 11 may have a purity ranging from 2N (99%) to 3N (99.9%). In other words, the first substrate layer 11 is an industrial-grade silicon that is readily available at low cost. For the instant embodiment, the first substrate layer 11 is an industrial-grade silicon supplied by Yuxin Chemical of grade 411, 421, 553, 2202, 3303, etc. In addition, the thickness of the first substrate layer 11 approximately ranges from 160 µm to 180 µm.

The second substrate layer 12 is formed on the first substrate layer 11. In comparison to the first substrate layer 11, the second substrate layer 12 is a high purity silicon. The corresponding purity ranges from 6N (99.9999%) to 9N (99.9999999%). In addition, the thickness of the second substrate layer 12 ranges from 5 um to 20 um. The aforementioned second substrate layer 12 mainly is a high purity type silicon, also known as the electronic grade silicon (EG-Si). This second substrate layer 12 serves as the active layer in a solar cell. Moreover, the thickness of the second substrate layer 12 is preferably smaller than the electron diffusion length to prevent the recombination of the electrons and holes, while also reducing the usage of the high purity silicon to save the manufacturing cost.

The second substrate layer 12 can be formed on the first substrate layer 11 by means of physical vapor deposition (PVD), chemical vapor deposition (CVD), liquid-phase epitaxy (LPE), etc.

The instant embodiment forms the second substrate layer 12, which is a poly-silicon (p-Si) overlayer, on the first substrate layer 11 by means of chemical vapor deposition. The silicon-precursor gas used may be dichlorsilane (SiH₂Cl₂), and the other reactant gas may be diborane (B₂H₆) consisting of boron and hydrogen. The chemical process is performed under a temperature ranging from 1000°C to 1100°C for 20 to 30 minutes. Thereby, the epitaxial poly-silicon second substrate layer 12 having a thickness of 15 micrometers may be grown. Furthermore, the second substrate layer 12 may turn out to be an amorphous layer after certain fabricating process. For such case, laser crystallization may be used to turn the second substrate layer 12 into a polycrystalline structure. For example, the amorphous second substrate layer 12 may be exposed under excimer laser. For within a laser pulse duration of 20 nanoseconds, the second substrate layer 12 can be heated up to approximately 1400°C. After the heat treatment, the second substrate layer 12 would begin to cool down and crystallize.

Furthermore, in another embodiment, the second substrate layer 12 can also be a sputtered layer. For sputter deposition, the pulsed DC magnetron sputtering technique may be used to grow a silicon film on the first substrate layer 11. The working pressure is from about 5x10⁻⁷ Torr to about 9 x 10⁻⁷ Torr. The sputtering power ranges from 100W to 300W, and the process temperature is in the range of 200°C to 250°C. The deposition pressure is approximately 5 mTorr, and argon is used as the sputtering gas with a flowrate of 8 to 10 sccm.

Thus, on the low-purity/low-cost first substrate layer 11, the high-purity second substrate layer 12 can be formed as the active layer for the solar cell. This composite poly-silicon substrate of the instant disclosure may be used as the poly-silicon substrate for the solar cell, while reducing the manufacturing cost of the solar cell substrate.

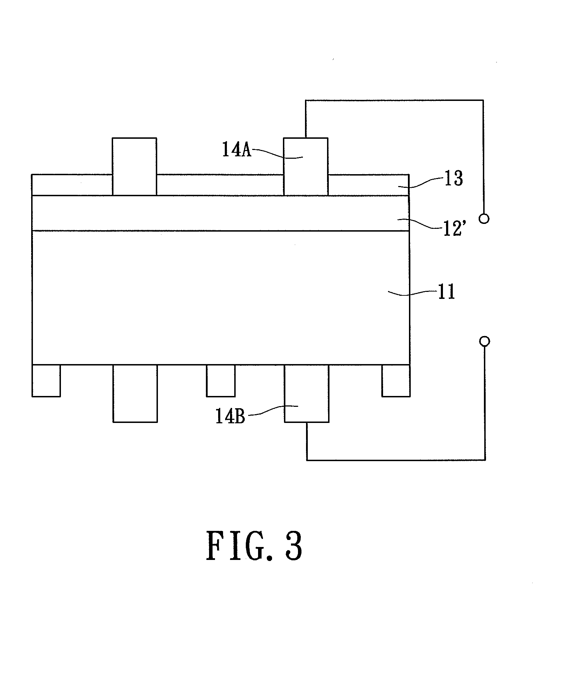

Please refer to Fig. 3, which shows a solar cell having the poly-silicon substrate of the instant disclosure. The solar cell includes the first substrate layer 11, the second substrate layer 12, and electrodes 14A, 14B arranged on the poly-silicon substrate. Since the first substrate layer 11 is already described in earlier paragraphs, no further description is provided herein. Meanwhile, a phosphorus-doped n⁺-Si emitter layer 12' may be formed from the second substrate layer 12 with thermal diffusion of phosphorous atoms or ion implantation. Preferably, the solar cell further includes an antireflection coating 13 formed on the emitter layer 12'. Material such as silicon nitride may be used for the antireflection coating. The electrode 14A arranged on the emitter layer 12' can be made with titanium, palladium, gold, or a combination thereof. Whereas the electrode 14B on the opposite side of the poly-silicon substrate can be formed with alumina gel having high electrical conductivity. The electrode 14B is arranged on the undersurface of the first substrate layer 11.

Based on the above, the instant disclosure has the following advantages. The formation of high purity silicon on the low purity silicon significantly reduces the total cost of the silicon substrate. Thus, the conventional high-cost / high-purity bulk substrate can be replaced. This composite poly-silicon substrate is applicable to solar cells to provide high efficiency at low manufacturing cost.

The descriptions illustrated *supra* set forth simply the preferred embodiments of the instant disclosure; however, the characteristics of the instant disclosure are by no means restricted thereto. All changes, alternations, or modifications conveniently considered by those skilled in the art are deemed to be encompassed within the scope of the instant disclosure delineated by the following claims.

## Claims

1. A composite poly-silicon substrate for solar cell comprising:
a first substrate layer (11) having a purity ranging from 2N to 3N; and
a second substrate layer (12) formed on the first substrate layer (11), wherein the purity of the second substrate layer (12) ranges from 6N to 9N.

2. The composite poly-silicon substrate for solar cell of claim 1, wherein the thickness of the first substrate layer (11) ranges from 160 um to 180 um.

3. The composite poly-silicon substrate for solar cell of claim 2, wherein the thickness of the second substrate layer (12) ranges from 5 um to 20 um.

4. The composite poly-silicon substrate for solar cell of claim 1, wherein the second substrate layer (12) is a sputtered layer.

5. A solar cell, comprising:
a poly-silicon substrate having a first substrate layer (11) and a second substrate layer (12) formed on the first substrate layer (11), wherein the purity of the first substrate layer (11) ranges from 2N to 3N, while the purity of the second substrate layer (12) ranges from 6N to 9N;
an emitter layer (12') transformed from the second substrate layer (12) after a predetermined fabrication process; and
a plurality of electrodes (14A,14B) arranged on the poly-silicon substrate.

6. The solar cell of claim 5, wherein the thickness of the first substrate layer (11) ranges from 160 um to 180 um.

7. The solar cell of claim 6, wherein the thickness of the second substrate layer (12) ranges from 5 um to 20 um.

8. The solar cell of claim 7, wherein at least one electrode (14A) is arranged on the emitter layer (12') and at least one electrode (14B) is arranged on the first substrate layer (11).

9. The solar cell of claim 7, further comprising an antireflection coating (13) formed on the emitter layer.

10. The solar cell of claim 7, wherein the second substrate layer (12) is a sputtered layer.
